# FASCICULE DE BREVET EUROPEEN

(11) **EP 1 775 595 B1**
(45) Date de publication et mention de la délivrance du brevet: **06.07.2011**
(21) Numéro de dépôt: 06122129.7
(22) Date de dépôt: 11.10.2006
(51) Int. Cl.: G01R 31/3183

(54) **Simulateur de test de circuits intégrés**
Testsimulator für integrierte Schaltkreise
Integrated circuit test simulator

(30) Priorité: 12.10.2005 FR 0553105
(43) Date de publication de la demande: 18.04.2007
(73) Titulaire: PROTON WORLD INTERNATIONAL N.V., 1930 Zaventem (BE)
(72) Inventeur: Van Assche, Gilles, 1030, BRUXELLES (BE); Modave, Jean-Louis, 1340, OTTIGNIES (BE)
(74) Mandataire: de Beaumont, Michel

(56) Documents cités:
- DE-A1- 10 328 237
- US-B1- 6 295 623

## Description

### Domaine de l'invention

La présente invention concerne de façon générale le test des circuits électroniques et, plus particulièrement, les systèmes de test fonctionnel de cartes à puce par une exécution en parallèle de différents scénarios par la carte à tester et par un simulateur, associé à l'outil de test et reproduisant les fonctions (jeu d'instructions) d'une carte.

### Exposé de l'art antérieur

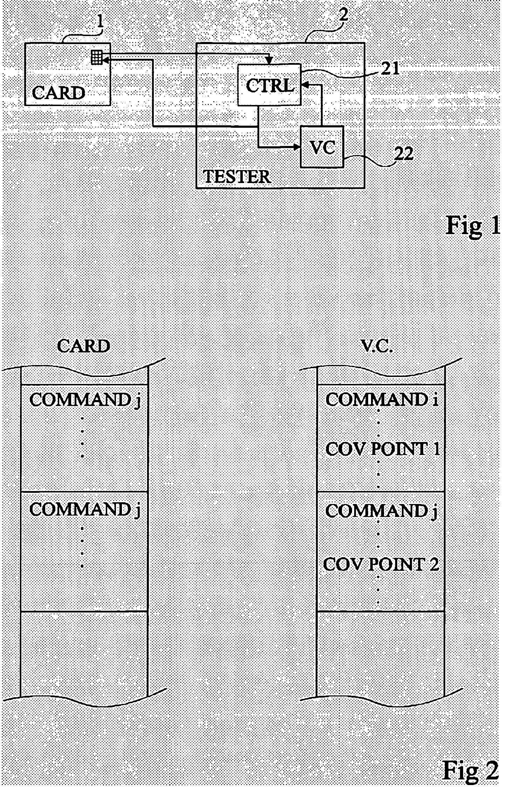

La figure 1 représente, de façon très schématique et sous forme de blocs, un exemple classique d'un système de test fonctionnel de cartes à puce 1 (CARD) au moyen d'un testeur 2 (TESTER) du type auquel s'applique la présente invention. Le testeur 2 est le plus souvent un système informatique capable d'échanger des données et des commandes avec la carte à puce 1 à tester (plus généralement, avec le circuit électronique à tester) que ce soit avec ou sans contact. Le testeur comporte fonctionnellement un circuit de commande 21 (CTRL) destiné à déclencher des séquences d'instructions logicielles (scénarios) à la fois dans la carte 1 à tester et dans une fonction 22 (VC) simulant une carte et constituant une carte virtuelle. La fonction de simulation 22 est généralement programmée dans le testeur 2 dont le circuit de commande 21 est lui-même programmé pour contenir différents scénarios en fonction des applications des cartes à tester. La représentation de la figure 1 est très simplifiée, le testeur pouvant en pratique être réalisé au moyen d'un ordinateur.

Le rôle du test fonctionnel auquel s'applique la présente invention consiste à vérifier que la carte à tester 1 réagit correctement aux différentes commandes en comparant les états qu'elle fournit à ceux restitués par le simulateur de référence 22 qui est supposé correct. Le plus souvent, le test consiste à placer la carte dans des situations (états logiciels et/ou matériels) normales et anormales pour vérifier qu'elle se comporte correctement.

En pratique, la carte possède un jeu d'instructions et de commandes qui sont exploitées par des programmes chargés dans une mémoire de sa puce (par exemple, des applications java). Le simulateur comporte le même jeu d'instructions pour être en mesure d'exécuter les mêmes programmes, côté testeur.

Un problème qui se pose est qu'il est en pratique impossible de tester toutes les combinaisons possibles d'états et de commandes. On est généralement conduit à sélectionner un nombre de commandes et d'ensembles d'états que le concepteur considère comme sensibles ou représentatifs et devant être testés.

Un problème est alors de vérifier que les scénarios de test ont bien mis en oeuvre toutes les étapes considérées comme sensibles ou représentatives.

Une solution connue pour tenter de résoudre ce problème est de vérifier qu'en fin de test, toutes les lignes du logiciel embarqué dans la carte à puce aient été adressées au moins une fois. Cela revient à vérifier au fur et à mesure du test si chaque ligne du programme embarqué dans la carte est atteinte par au moins une commande d'au moins un scénario. Un tel test peut être effectué avec un émulateur ou simulateur de circuit intégré.

Un inconvénient de cette technique est qu'elle ne tient pas compte de l'état de la carte et notamment de variables traitées par les instructions comme, par exemple, le solde ou balance d'un porte-monnaie électronique. Or, dans de nombreux cas, l'état de la carte est important pour s'assurer que le programme de la carte est capable de traiter correctement des valeurs particulières (par exemple des valeurs limites comme un porte-monnaie vide ou un porte monnaie au solde maximum dans une application de porte-monnaie électronique).

Le document US-B-6295623 décrit un système de test de versions réelle et simulée d'un circuit intégré et prévoit de vérifier qu'un signal de sortie d'un circuit intégré respecte la séquence de valeurs indiquée par une séquence de données correspondant au signal de sortie simulé.

Le document DE-A-10328237 décrit un procédé de génération de données de test pour un test fonctionnel d'un circuit de traitement de données et prévoit également des comparaisons entre des valeurs fournies par un simulateur et par le circuit testé.

### Résumé de l'invention

La présente invention vise à pallier tout ou partie des inconvénients des systèmes connus de test et plus particulièrement de test fonctionnel de cartes à puce au moyen d'un simulateur représentant une carte virtuelle.

La présente invention vise également, dans un test de carte à puce, à contrôler que des étapes incluant des commandes et des états de la carte considérés comme sensibles ou représentatifs aient bien été traitées par les scénarios de test.

L'invention vise également à proposer une solution compatible avec les systèmes de test actuels et, notamment, n'engendrant aucune modification structurelle des outils de test.

L'invention vise également à ne nécessiter aucune modification structurelle ou logicielle des cartes à tester.

Pour atteindre tout ou partie de ces objets ainsi que d'autres, la présente invention prévoit un procédé de test d'un circuit électronique par exécution en parallèle d'un programme dans ce circuit et dans un simulateur, comportant une étape de vérification que des commandes et conditions contenues dans le simulateur ont bien été exécutées lors du test.

Selon un mode de mise en oeuvre de la présente invention, lesdites conditions sont des états de variables du simulateur.

Selon un mode de mise en oeuvre de la présente invention, le test est considéré comme complet si toutes les commandes et conditions ont été atteintes lors du test.

Selon un mode de mise en oeuvre de la présente invention, un circuit électronique testé est considéré comme fonctionnellement correct si toutes les commandes et conditions ont été atteintes lors du test et si toutes les réponses données par le circuit électronique sont en accord avec celles du simulateur.

La présente invention prévoit également un simulateur d'un circuit électronique en vue du test d'autres circuits par exécution en parallèle de programmes contenus dans ces circuits et dans le simulateur, des instructions de détection d'exécution étant insérées dans des commandes du simulateur.

Selon un mode de réalisation de la présente invention, lesdites instructions de détection prennent en compte la commande exécutée et une condition sur au moins une variable du simulateur.

La présente invention prévoit également un système de test de cartes à puce par exécution en parallèle d'un programme de test dans une carte à tester et dans un simulateur, le simulateur comportant des moyens pour vérifier que des instructions et conditions considérées comme sensibles ou représentatives de son jeu de commandes sont atteintes pendant le test.

### Brève description des dessins

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
la figure 1 qui a été décrite précédemment représente de façon très schématique et sous forme de blocs, un exemple de système de test du type auquel s'applique la présente invention ; et
la figure 2 illustre un mode de mise en oeuvre du procédé de test selon la présente invention.

Par souci de clarté, seuls les étapes et éléments utiles à la compréhension de l'invention ont été représentés aux figures et seront décrits par la suite. En particulier, les échanges entre le système de test, la carte virtuelle (simulateur) et la carte à tester n'ont pas été détaillés, l'invention étant compatible avec les systèmes classiques. De plus, la création des scénarios fonctionnels n'a pas été non plus détaillée, l'invention étant là encore compatible avec les systèmes classiques.

### Description détaillée

Une caractéristique d'un mode de mise en oeuvre et de réalisation de l'invention est d'intégrer, dans le simulateur de référence et plus particulièrement dans son jeu de commandes, des instructions de détection destinées à s'assurer que les commandes concernées aient bien été exécutées lors du test.

La présente invention tire profit du fait que le simulateur est utilisé en parallèle avec la carte à tester et reçoit les mêmes commandes de l'appareil de test. Ainsi, vérifier l'exécution de commandes ou de procédures particulières dans l'outil de simulation revient au même que de s'assurer qu'elles ont été exécutées côté carte. Il n'est donc pas nécessaire de modifier la carte ou son programme pour la mise en oeuvre de l'invention.

Les suites données par la carte et le simulateur à ces commandes font partie du test fonctionnel classique. Ce qui importe pour l'invention, c'est de détecter que des conditions particulières (commande + état) aient bien été atteintes lors du test.

En pratique, le créateur du simulateur et de l'appareil de test (définition des scénarios) n'est pas le même que le créateur du programme de la carte. Ceci est particulièrement le cas dans le cadre d'applications paramétrables en fonction de la destination de carte. Toutefois, tous les programmes applicatifs utilisent des mêmes instructions de base ou des mêmes commandes (groupes instructions et de variables) de sorte qu'il est possible d'établir des scénarios de test mettant en oeuvre les différentes instructions.

Lors de l'écriture du programme constituant le simulateur de la carte, le concepteur détermine quelles sont commandes et conditions qui doivent être vérifiées (considérées comme sensibles ou représentatives). Ces éléments définissent ce que l'on appelle des points de couverture correspondant à une ligne de programme dans le simulateur de référence associée à une condition de l'état du simulateur (donc de la carte testée) au même moment. Un point de couverture est atteint si, lors des tests, le simulateur de référence passe par la ligne où se trouve cette instruction et que la condition sur l'état est vérifiée.

Par la suite, l'appareil de test exécute des scénarios liés à l'application qui vont faire appel à différentes instructions et conditions de la carte et du simulateur. La création des scénarios de test est indépendante de l'introduction dans le simulateur de points de couverture. Ainsi, on vérifie bien que tous les points de couverture ont été atteints par les différents scénarios de test.

La figure 2 illustre, de façon très schématique, un mode de mise en oeuvre de l'invention. Il s'agit d'un programme côté simulateur de référence (VC ou Virtuel Card). Dans plusieurs commandes (par exemple 2) COMMANDi et COMMANDj, on prévoit des points de couverture, par exemple, COV POINT1 et COV POINT2. Les mêmes commandes côté carte (CARD) ne comportent pas les lignes correspondant aux points de couverture. Lorsqu'une application exécutée par le test est envoyée à la fois sur la carte à tester (1, figure 1) et le simulateur de référence, ce dernier fait appel à l'une des deux commandes, le testeur mémorise alors que le point de couverture correspondant a été atteint.

En fin de test, on vérifie que tous les points de couverture définis dans la carte de référence ont bien été parcourus par le test.

Côté appareil de test, il faut comptabiliser les points de couverture (que ce soit sous forme de compteur d'événements ou sous forme de table) atteints lors du test pour être en mesure de vérifier que tous les points de couverture requis ont bien été parcourus par le test. De plus, les points de couverture définis dans le simulateur sont recensés pour pouvoir comparer l'ensemble des points atteints avec l'ensemble de points à atteindre.

Un avantage de la présente invention est qu'elle permet de tester tous les points sensibles ou représentatifs d'une carte indépendamment de l'application qui y est exécutée sans pour autant requérir un test exhaustif de l'ensemble des instructions et conditions. Seules les instructions et conditions considérées comme sensibles ou représentatives par le concepteur de la carte, donc du simulateur seront prises en compte.

Un avantage de la présente invention est qu'elle prend en compte non seulement l'exécution d'une instruction particulière dans la carte mais également une condition sur son état.

En reprenant l'exemple du porte-monnaie électronique, on suppose que deux conditions sur le solde (balance) de la carte sont critiques, car proches de la balance maximale (BALMAX) ou de la balance minimum (BALMIN). Dans une opération de crédit de la carte correspondant à un scénario de test, la balance (variable BAL) ne doit pas dépasser le seuil maximum. Dans une opération de débit de la carte qui correspond à un autre scénario de test, la balance ne doit pas devenir inférieure à la balance minimale. Les vérifications de ces conditions sont contenues dans les programmes de la carte et du simulateur de référence sous la forme de commandes particulières comparant la balance courante et le montant courant par rapport à la balance maximale ou à la balance minimale.

Selon un mode de réalisation de l'invention, on insère côté simulateur de référence dans les commandes correspondantes, des lignes correspondant à des points de couverture en ajoutant à chaque fois la condition sur la balance maximale et minimale. Ainsi, lors de l'exécution des scénarios de test de crédit et de débit, les points de couverture seront considérés comme atteints uniquement si les tests sont effectués avec des montants d'incrément ou de décrément respectivement conduisant à des valeurs de balance compatibles avec les seuils prévus.

Bien entendu, la présente invention est susceptible de diverses variantes et modifications qui apparaîtront à l'homme de l'art. En particulier, bien que l'invention ait été décrite plus particulièrement en relation avec une application aux cartes à puce de type porte-monnaie électronique, elle s'applique plus généralement à tout test de circuit électronique dans lequel on utilise un circuit de référence exécutant en parallèle les mêmes instructions que le circuit à tester. De plus, la mise en oeuvre de l'invention est à la portée de l'homme du métier à partir des indications fonctionnelles données ci-dessus, notamment pour ce qui concerne le choix des instructions et conditions considérées comme sensibles ou représentatives et devant être parcourues lors des tests fonctionnels.

A titre d'exemple de mise en oeuvre, on prévoit un tableau dans lequel chaque ligne correspond à un point de couverture. Par exemple, chaque ligne est déterminée soit par son rang dans le tableau, soit par un identifiant logique choisi par le concepteur du simulateur. Au début de l'exécution par l'appareil de test, aucune ligne n'est marquée. Un point de couverture peut être concrétisé par une instruction qui marque une certaine ligne du tableau, référencée soit par son rang, soit par un identifiant logique. Cette instruction est préfixée par la condition sur l'état actuel du simulateur. Ainsi, une ligne du tableau sera marquée si et seulement si le point de couverture correspondant est atteint.

## Revendications

1. Procédé de test d'un circuit électronique par exécution en parallèle d'un programme dans ce circuit (1) et dans un simulateur (22), **caractérisé en ce qu'**il comporte une étape de vérification que des commandes et des conditions, représentant des états de variables du simulateur et contenues dans celui-ci, ont bien été exécutées lors du test, cette étape étant indépendante d'une vérification que les réponses données par le circuit sont en accord avec celles du simulateur.

2. Procédé selon la revendication 1, dans lequel le test est considéré comme complet si toutes les commandes et conditions ont été atteintes lors du test.

3. Procédé selon l'une quelconque des revendications 1 et 2, dans lequel un circuit électronique testé est considéré comme fonctionnellement correct si toutes les commandes et conditions ont été atteintes lors du test et si toutes les réponses données par le circuit électronique sont en accord avec celles du simulateur.

4. Simulateur (22) d'un circuit électronique en vue du test d'autres circuits (1) configuré pour l'exécution en parallèle de programmes contenu dans ces circuits et dans le simulateur, **caractérisé en ce que** des instructions de détection d'exécution prenant en compte la commande exécutée et une condition sur au moins un état de variable du simulateur sont insérées dans des commandes du simulateur.

5. Système de test (2) de cartes à puce par exécution en parallèle d'un programme de test dans une carte à tester (1) le système comprenant un simulateur (22) selon la revendication 4, le simulateur comportant des moyens pour vérifier que des instructions et conditions considérées comme sensibles ou représentatives de son jeu de commandes sont atteintes pendant le test.

## Claims

1. A method for testing an electronic circuit by parallel execution of a program in this circuit (1) and in a simulator (22), **characterized in that** it comprises a step of checking that commands and conditions representing states of variables of the simulator and contained in the simulator have effectively been executed during the test, this step being independent from a checking that the responses provided by the circuit are in agreement with those from the simulator.

2. The method of claim 1, wherein the test is considered as complete when all commands and conditions have been reached in the testing.

3. The method of claim 1 or 2, wherein a tested electronic circuit is considered as functionally correct if all the commands and conditions have been reached in the testing and if all the responses of the electronic circuit are in accordance with those of the simulator.

4. A simulator (22) of an electronic circuit for the testing of other circuits (1) arranged for the parallel execution of programs contained in these circuits and in the simulator, **characterized in that** execution detection instructions taking into account the executed command and a condition on at least one variable state of the simulator are inserted in commands of the simulator.

5. A system (2) for testing smart cards by parallel execution of a test program in a card to be tested (1), the system comprising the simulator (22) of claim 4, the simulator comprising means for checking whether instructions and conditions considered as critical or representative of its set of commands are reached during the test.

## Patentansprüche

1. Ein Verfahren zum Testen einer elektronischen Schaltung durch die Parallelausführung eines Programms in dieser Schaltung (1) und in einem Simulator (22) **dadurch gekennzeichnet, dass** Folgendes vorgesehen ist:
ein Schritt des Prüfens, dass Befehle und Bedingungen, die die Zustände der Variablen des Simulators repräsentieren und in dem Simulator enthalten sind in effektiver Weise während des Tests ausgeführt wurden, wobei dieser Schritt unabhängig ist von einer Überprüfung, dass das Ansprechen (die Ansprechvorgänge) vorgesehen durch die Schaltung in Übereinstimmung mit denjenigen vom Simulator, sind.

2. Verfahren nach Anspruch 1, wobei der Test als vollständig betrachtet wird, wenn alle Befehle und Bedingungen in dem Test erreicht sind.

3. Verfahren nach Anspruch 1 oder 2, wobei eine getestete elektronische Schaltung als funktionell korrekt angesehen wird, wenn alle die Befehle und Bedingungen in dem Test erreicht wurden, und wenn alle Ansprechvorgänge der elektronischen Schaltung entsprechend denjenigen des Simulators sind.

4. Ein Simulator (22) einer elektronischen Schaltung zum Testen von anderen Schaltungen (1) angeordnet für die Parallelausführung von Programmen enthalten in diesen Schaltungen und in dem Simulator, **dadurch gekennzeichnet, dass** die Ausführungsdetektionsbefehle den ausgeführten Befehl und eine Bedingung berücksichtigen hinsichtlich mindestens einen variablen Zustands des Simulators, und wobei diese Ausführungsdetektionsbefehle in Befehle des Simulators eingesetzt sind.

5. Ein System (2) zum Testen von Smartcards durch parallele Ausführung eines Testprogramms in einer zu testenden Karte (1), wobei das System den Simulator (22) nach Anspruch 4 aufweist, wobei der Simulator Mittel aufweist zum Überprüfen, ob Befehle und Bedingungen, die als kritisch oder repräsentativ angesehen werden, und zwar in seinem Satz von Befehlen, während des Test erreicht werden.
